# EUROPÄISCHE PATENTSCHRIFT

(11) **EP 3 948 312 B1**
(45) Veröffentlichungstag und Bekanntmachung des Hinweises auf die Patenterteilung: **03.04.2024**
(21) Anmeldenummer: 20704862.0
(22) Anmeldetag: 11.02.2020
(51) Int. Cl.: G01R 19/165, G01R 31/396, G01R 19/25

(54) **VORRICHTUNG UND VERFAHREN ZUM BESTIMMEN EINER ELEKTRISCHEN ZELLSPANNUNG EINER BATTERIEZELLE EINER TRAKTIONSBATTERIE EINES FAHRZEUGS**
DEVICE AND METHOD FOR DETERMINING AN ELECTRICAL CELL VOLTAGE OF A BATTERY CELL OF A TRACTION BATTERY OF A VEHICLE
DISPOSITIF ET PROCÉDÉ DE DÉTERMINATION D'UNE TENSION DE CELLULE ÉLECTRIQUE D'UN ÉLÉMENT DE BATTERIE D'UNE BATTERIE DE TRACTION D'UN VÉHICULE

(30) Priorität: 29.03.2019 DE 102019002309
(43) Veröffentlichungstag der Anmeldung: 09.02.2022
(73) Patentinhaber: Mercedes-Benz Group AG, 70372 Stuttgart (DE)
(72) Erfinder: MAIER, Andreas, 73066 Uhingen (DE)
(74) Vertreter: Novagraaf Group
(86) Internationale Anmeldenummer: PCT/EP2020/053488
(87) Internationale Veröffentlichungsnummer: WO 2020/200558

(56) Entgegenhaltungen:
- EP-A1- 3 037 830
- EP-A2- 1 798 838
- WO-A1-2011/043311
- US-A1- 2014 266 224

## Beschreibung

Die Erfindung betrifft ein Verfahren zum Bestimmen einer elektrischen Zellspannung einer Batteriezelle einer Traktionsbatterie eines Fahrzeugs, bei welchem zum Bereitstellen eines Zellspannungssignals, welches die Zellspannung der Batteriezelle beschreibt, die Zellspannung der Batteriezellen mit einer Filtereinrichtung gefiltert wird und die gefilterte Zellspannung mit einem Analog-Digital-Wandler abgetastet wird, wobei das Zellspannungssignal ausgewertet wird. Des Weiteren betrifft die Erfindung eine Vorrichtung zum Bestimmen einer elektrischen Zellspannung einer Batteriezelle einer Traktionsbatterie eines Fahrzeugs.

Aus dem Stand der Technik sind unterschiedliche Verfahren zum Bestimmen der Zellspannung einer Batteriezelle bekannt. Die Erfassung der Zellspannung jeder einzelnen Batteriezelle einer Traktionsbatterie eines Fahrzeugs ist erforderlich, um beispielsweise den Betrieb der Batteriezelle zu überwachen und/oder einen Ladevorgang der Batterie zu steuern. Damit die Zellspannung einer Batteriezelle erfasst und entsprechend ausgewertet werden kann, ist es erforderlich, die Zellspannung zu digitalisieren beziehungsweise diese abzutasten. Zudem ist es aus dem Stand der Technik bekannt, dass eine entsprechende Filterung beziehungsweise Befilterung der Zellspannung beziehungsweise der Zellspannungsmesswerte mit einem Tiefpassfilter durchgeführt wird. Hierbei kann die Eckfrequenz des Tiefpassfilters so gewählt werden, dass diese unter der halben Abtastrate des Messsignals liegt, damit das Nyquist-Shannon-Abtasttheorem erfüllt ist.

Zudem sind andere Ansätze bekannt, bei denen davon ausgegangen wird, dass die entsprechenden Frequenzanteile im Spektrum keine relevante Amplitude aufweisen und daher kein Aliasing auftritt. Ein derartiger Ansatz kann aber beim Laden der Batterie an einer DC-Ladesäule nicht verwendet werden, da die entsprechende Norm eine Spannungswelligkeit im relevanten Frequenzbereich zulässt.

Eine weitere Option stellt die Überabtastung und anschließende digitale Filterung dar. Um mit dieser Methode sichere Messwerte bereitzustellen, ist es erforderlich, dass jede Zellspannung durchgehend digitalisiert wird. Somit wird pro Zellkanal beziehungsweise pro Batteriezelle ein Analog-Digital-Wandler benötigt, da das Multiplexen mehrerer Zellspannungen auf einen Analog-Digital-Wandler nicht möglich ist.

In diesem Zusammenhang beschreibt die US 2017/0038434 A1 ein Gerät zur Leistungsversorgung, welches eine Batterie mit einer Mehrzahl von Batteriezellen, eine Mehrzahl von Messleitungen, eine Filterschaltung sowie einen Analog-Digital-Wandler umfasst. Die Filterschaltung ist aufgebaut aus Eingangsanschlüssen, Ausgangsanschlüsse, Filterwiderständen und Filterkondensatoren, von denen ein Ende jeweils zwischen die Filterwiderstände und die Ausgangsanschlüsse geschaltet ist und die anderen Enden gemeinsam miteinander verbunden sind.

Weiterhin ist aus der WO 2011/043311 A1 eine Batteriespannungsmessvorrichtung offenbart. Diese umfasst einen A/D-Wandler, der die Spannung einer Batteriezelle misst und den Spannungswert in einen digitalen Spannungswert umwandelt. Zudem umfasst die Batteriespannungsmessvorrichtung ein Kommunikationsmittel, das den digitalen Spannungswert überträgt und ein Mikrocomputer, der den digitalen Spannungswert erhält. Schließlich umfasst die Batteriespannungsmessvorrichtung einen analogen Tiefpassfilter, welcher zwischen Batteriemodulen und dem A/D-Wandler eingefügt ist, und einen digitalen Tiefpassfilter, welcher zwischen dem A/D-Wandler und dem Kommunikationsmittel eingefügt ist. Der digitale Tiefpassfilter schneidet Frequenzen ab, die größer oder gleich der halben Abtastfrequenz des vom Mikrocomputer erhaltenen digitalen Spannungswerts sind, und stellt die Abtastfrequenz des A/D-gewandelten digitalen Spannungswerts höher als die Abtastfrequenz des vom Mikrocomputer erhaltenen digitalen Spannungswerts ein. Der analoge Tiefpassfilter unterdrückt Frequenzen, die größer oder gleich der halben Abtastfrequenz der A/D-gewandelten Batteriespannung sind.

Schließlich ist aus der US 2014/266224 A1 ein Verfahren zur Verringerung des Einflusses der Spannungswelligkeit auf Batterietestmessungen von in Reihe geschalteten Batteriezellen, die einen Gleichstrombus (DC) bilden, offenbart. Ein Kalibrierungsvorgang wird verwendet, um eine ratiometrische Differenz zwischen einer ersten und einer zweiten in Reihe geschalteten Batteriezelle des Gleichstrombusses zu erhalten, die eine Abweichung in ihren jeweiligen Ausgangsspannungen anzeigt.

Spannungsmessungen an jeder der beiden Zellen können dann zumindest im Wesentlichen gleichzeitig durchgeführt werden. Die ratiometrische Differenz kann dazu verwendet werden, die Spannungsmessung an der zweiten Zelle zu modifizieren, um eine modifizierte Spannungsmessung an der zweiten Zelle zu erhalten. Anschließend kann eine Differenz zwischen der gemessenen Spannung an der ersten Batteriezelle und der modifizierten Spannungsmessung ermittelt werden, die eine gefilterte Prüfgleichspannung darstellt, aus der im Wesentlichen die gesamte Spannungswelligkeit entfernt wurde.

Es ist Aufgabe der vorliegenden Erfindung, eine Lösung aufzuzeigen, wie die Bestimmung der Zellspannung einer Batteriezelle einer Traktionsbatterie auf kostengünstige Weise und sicher durchgeführt werden kann.

Diese Aufgabe wird erfindungsgemäß durch ein Verfahren sowie durch eine Vorrichtung mit den Merkmalen gemäß den unabhängigen Ansprüchen gelöst.

Ein erfindungsgemäßes Verfahren dient zum Bestimmen einer elektrischen Zellspannung einer Batteriezelle einer Traktionsbatterie eines Fahrzeugs. Bei dem Verfahren wird zum Bereitstellen eines Zellspannungssignals, welches die Zellspannung der Batteriezelle beschreibt, die Zellspannung der Batteriezellen mit einer Filtereinrichtung gefiltert und die gefilterte Zellspannung mit einem Analog-Digital-Wandler abgetastet, wobei das Zellspannungssignal ausgewertet wird. Dabei ist vorgesehen, dass zusätzlich ein Welligkeitswert bereitgestellt wird, welcher eine Welligkeit der Zellspannung beschreibt. Des Weiteren wird das Zellspannungssignal in Abhängigkeit von dem Welligkeitswert ausgewertet.

Mithilfe des Verfahrens kann die elektrische Zellspannung der Batteriezelle bestimmt und ausgewertet werden. Die Batteriezelle ist Teil der Traktionsbatterie, wobei die Traktionsbatterie eine Mehrzahl von Batteriezellen umfasst, die elektrisch in Reihe und/oder parallel geschaltet sind. Das Verfahren kann für jede der Batteriezellen durchgeführt werden. Die Traktionsbatterie kann insbesondere dazu dienen, einen Antriebsmotor eines Elektrofahrzeugs oder eines Hybridfahrzeugs mit elektrischer Energie zu versorgen. Um die Zellspannung der Batteriezelle auswerten zu können, wird das Zellspannungssignal bereitgestellt. Zu diesem Zweck wird die elektrische Zellspannung, die beispielsweise mit einem entsprechenden ersten Sensor als analoges Signal gemessen werden kann, gefiltert. Zum Filtern der Zellspannung wird eine entsprechende Filtereinrichtung beziehungsweise ein Tiefpassfilter verwendet. Dabei kann die Zellspannung mit einer relativ hohen Eckfrequenz, beispielsweise mit einer Eckfrequenz von 1 kHz, gefiltert werden. Im Anschluss daran wird die gefilterte Zellspannung mit dem Analog-Digital-Wandler abgetastet. Beispielsweise kann die Abtastung mit einer Abtastrate von 100 Hz erfolgen. Dabei können Verfälschungen durch Aliasing-Effekte in Kauf genommen werden.

Es ist vorgesehen, dass mit einem zweiten Sensor der Welligkeitswert bereitgestellt wird. Grundsätzlich kann mit dem zweiten Sensor ebenfalls eine elektrische Spannung erfasst werden und hieraus der Welligkeitswert abgeleitet werden. Dieser Welligkeitswert beschreibt die Spannungswelligkeit der Zellspannung im relevanten Frequenzbereich, insbesondere in einem Frequenzbereich zwischen 50 Hz und 2 kHz, mit einer hohen Bandbreite. Dabei wird die Spannungswelligkeit zunächst für die von der Traktionsbatterie bereitgestellte Gesamtspannung bestimmt und anschließend auf die Zellebene skaliert. Der Welligkeitswert ist ein Maß für die maximale Aliasing-induzierte Messabweichung, die auf Zellebene zu berücksichtigen ist. Dieser Welligkeitswert wird von der Recheneinrichtung bei der Auswertung des Zellspannungssignals berücksichtigt. Mit anderen Worten erfolgt die Auswertung des Zellspannungssignals auf Grundlage des Welligkeitswerts.

Durch das Verfahren wird es möglich, dass Anti-Aliasing Maßnahmen an zentraler Stelle erfolgen können. Damit kann auf kostspielige und große Tiefpassfilter auf Zellebene verzichtet werden. Zudem ist eine sichere Ermittlung der maximalen Zellspannung unabhängig von der vorliegenden Spannungswelligkeit möglich. Wenn keine hohen Störamplituden vorliegen, werden die Leistung und die Verfügbarkeit der Batterie gegenüber dem Status quo nicht reduziert.

Eine erfindungsgemäße Vorrichtung zum Bestimmten einer elektrischen Zellspannung einer Batteriezelle einer Traktionsbatterie eines Fahrzeugs umfasst einen ersten Sensor zum Erfassen der Zellspannung. Zudem umfasst die Vorrichtung eine Filtereinrichtung zum Filtern der Zellspannung. Des Weiteren umfasst die Vorrichtung einen Analog-Digital-Wandler zum Abtasten der gefilterten Zellspannung sowie zum Ausgeben der gefilterten und abgetasteten Zellspannung als Zellspannungssignal. Außerdem umfasst die Vorrichtung eine Recheneinrichtung zum Auswerten des Zellspannungssignals. Darüber hinaus ist vorgesehen, dass die Vorrichtung einen zweiten Sensor zum Bereitstellen eines Welligkeitswerts aufweist, wobei der Welligkeitswert eine Welligkeit der Zellspannung beschreibt. Fernern ist die Recheneinrichtung dazu ausgebildet, das Zellspannungssignal in Abhängigkeit von dem Welligkeitswert auszuwerten. Ebenso ist die Recheneinrichtung dazu ausgebildet, eine Spannungswelligkeit der Gesamtspannung in einem vorbestimmten Frequenzbereich, insbesondere in einem Frequenzbereich zwischen 50 Hz und 2 kHz, zu bestimmen, wobei diese Spannungswelligkeit ein zu berücksichtigendes Maß für eine maximale Aliasing-induzierte Messabweichung auf Zellebene ist, und - die Spannungswelligkeit für die Batteriezelle zu skalieren, sowie die gefilterte Zellspannung mit einer vorbestimmten Abtastrate, insbesondere einer Abtastrate zwischen 50 Hz und 200 Hz, welche Aliasing-Effekte bei der Zellspannungsbestimmung hervorruft, abzutasten.

Die mit Bezug auf das erfindungsgemäße Verfahren vorgestellten bevorzugten Ausführungsformen und deren Vorteile gelten entsprechend für die erfindungsgemäße Vorrichtung.

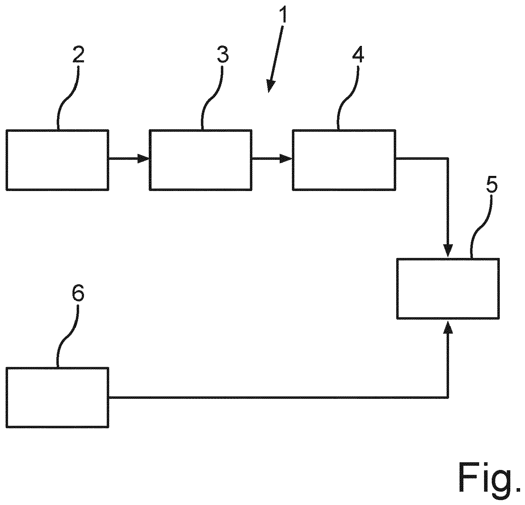

Weitere Vorteile, Merkmale und Einzelheiten der Erfindung ergeben sich aus der nachfolgenden Beschreibung eines bevorzugten Ausführungsbeispiels sowie anhand der Zeichnung. Die vorstehend in der Beschreibung genannten Merkmale und Merkmalskombinationen sowie die nachfolgend in der Figurenbeschreibung genannten und/oder in der einzigen Figur alleine gezeigten Merkmale und Merkmalskombinationen sind nicht nur in der jeweils angegebenen Kombination, sondern auch in anderen Kombinationen oder in Alleinstellung verwendbar.

Die einzige Figur zeigt eine schematische Darstellung einer Vorrichtung 1 zum Bestimmen einer Zellspannung einer Batteriezelle einer Traktionsbatterie eines Fahrzeugs. Diese Vorrichtung 1 kann beispielsweise in dem Fahrzeug angeordnet sein und im Betrieb des Fahrzeugs beziehungsweise während eines Ladevorgangs des Fahrzeugs die jeweiligen Zellspannungen der Batteriezellen erfassen. Die Vorrichtung 1 umfasst einen ersten Sensor 2, mittels welchem die Zellspannung einer Batteriezelle erfasst werden kann. Der erste Sensor kann als Spannungssensor ausgebildet sein. In der vorliegenden vereinfachten Darstellung umfasst die Vorrichtung 1 beispielhaft einen ersten Sensor 2. Es kann auch vorgesehen sein, dass die Vorrichtung 1 eine Mehrzahl von ersten Sensoren 2 aufweist. Beispielsweise kann die Vorrichtung 1 für jede der Batteriezellen einen ersten Sensor 2 aufweisen.

Darüber hinaus umfasst die Vorrichtung 1 eine Filtereinrichtung 3, mittels welcher die Zellspannung analog gefiltert werden kann. Die Filtereinrichtung 3 kann als Tiefpassfilter ausgebildet sein und eine Eckfrequenz zwischen 500 Hz und 1,5 kHz, bevorzugt 1 kHz, aufweisen. Des Weiteren umfasst die Vorrichtung 1 einen Analog-Digital-Wandler 4. Mit diesem Analog-Digital-Wandler 4 wird die gefilterte Zellspannung digitalisiert oder abgetastet. Die Digitalisierung kann mit einer Abtastrate zwischen 50 Hz und 200 Hz, bevorzugt mit einer Abtastrate von 100 Hz, durchgeführt werden. Dabei werden Verfälschungen durch Aliasing-Effekte in Kauf genommen. Die gefilterte und abgetastete Zellspannung wird als Zellspannungssignal an eine Recheneinrichtung 5 der Vorrichtung 1 übertragen. Mittels der Recheneinrichtung 5 kann das Zellspannungssignal ausgewertet werden.

Außerdem umfasst die Vorrichtung 1 einen zweiten Sensor 6, welcher ebenfalls als Spannungssensor ausgebildet ist. Mithilfe des zweiten Sensors 6 kann eine Spannungswelligkeit der Zellspannung in einem relevanten Frequenzbereich, insbesondere in einem Frequenzbereich zwischen 50 Hz und 2 kHz, erfasst werden. Hierbei ist es vorgesehen, dass eine elektrische Gesamtspannung der Traktionsbatterie mittels des zweiten Sensors 6 erfasst wird und hieraus die Spannungswelligkeit ermittelt wird. Die Spannungswelligkeit beschreibt insbesondere die Differenz zwischen einem Minimalwert und einem Maximalwert der Batteriespannungsmessung. Diese Spannungswelligkeit ist ein Maß für die maximale Aliasing-induzierte Messabweichung, die auf Zellebene zu berücksichtigen ist.

Zudem ist es vorgesehen, dass zur Bestimmung des Welligkeitswerts die Spannungswelligkeit auf die Zellebene skaliert wird. Beispielsweise kann die Spannungswelligkeit durch die Anzahl seriell verschaltet der Batteriezellen dividiert werden und kann dann zu dem (gemessenen) maximalen Zellspannungsmesswerten hinzuaddiert werden. Die Bestimmung des Welligkeitswerts kann mittels der Recheneinrichtung 5 durchgeführt werden. Es kann auch vorgesehen sein, dass eine zusätzliche Einrichtung zur die Bestimmung des Welligkeitswerts vorgesehen ist. Auf Grundlage des Welligkeitswerts kann dann das Spannungssignal mittels der Recheneinrichtung 5 ausgewertet werden.

Mithilfe der Vorrichtung 1 erfolgen Anti-Aliasing Maßnahmen an zentraler Stelle, wodurch kostspielige und große Tiefpassfilter auf Zellebene entfallen können.

### Bezugszeichenliste

- 1: Vorrichtung
- 2: erster Sensor
- 3: Filtereinrichtung
- 4: Analog-Digital-Wandler
- 5: Recheneinrichtung
- 6: zweiter Sensor

## Patentansprüche

1. Verfahren zum Bestimmen einer elektrischen Zellspannung einer Batteriezelle einer Traktionsbatterie eines Fahrzeugs, bei welchem zum Bereitstellen eines Zellspannungssignals, welches die Zellspannung der Batteriezelle beschreibt, die Zellspannung der Batteriezellen mit einer Filtereinrichtung (3) gefiltert wird und die gefilterte Zellspannung mit einem Analog-Digital-Wandler (4) abgetastet wird, wobei das Zellspannungssignal ausgewertet wird, wobei die Zellspannung mit einem Tiefpassfilter, insbesondere einem Tiefpassfilter mit einer Eckfrequenz zwischen 500 Hz und 1,5 kHz, gefiltert wird, sowie die gefilterte Zellspannung mit einer vorbestimmten Abtastrate, insbesondere einer Abtastrate zwischen 50 Hz und 200 Hz, abgetastet wird,
**dadurch gekennzeichnet, dass**
- zusätzlich ein Welligkeitswert bereitgestellt wird, welcher eine Welligkeit der Zellspannung beschreibt und zum Bestimmen des Welligkeitswerts eine elektrische Gesamtspannung der Traktionsbatterie bestimmt wird;
- das Zellspannungssignal in Abhängigkeit von dem Welligkeitswert ausgewertet wird;
- eine Spannungswelligkeit der Gesamtspannung in einem vorbestimmten Frequenzbereich, insbesondere in einem Frequenzbereich zwischen 50 Hz und 2 kHz, bestimmt wird, wobei diese Spannungswelligkeit ein zu berücksichtigendes Maß für eine maximale Aliasing-induzierte Messabweichung auf Zellebene ist;
- die Spannungswelligkeit für die Batteriezelle skaliert wird.

2. Vorrichtung (1) zum Bestimmen einer elektrischen Zellspannung einer Batteriezelle einer Traktionsbatterie eines Fahrzeugs, mit einem ersten Sensor (2) zum Erfassen der Zellspannung, mit einer Filtereinrichtung (3) zum Filtern der Zellspannung, mit einem Analog-Digital-Wandler (4) zum Abtasten der gefilterten Zellspannung sowie zum Ausgeben der gefilterten und abgetasteten Zellspannung als Zellspannungssignal und mit einer Recheneinrichtung (5) zum Auswerten des Zellspannungssignals,
**dadurch gekennzeichnet, dass**
die Vorrichtung (1) einen zweiten Sensor (6) zum Bereitstellen eines Welligkeitswerts aufweist, wobei der Welligkeitswert eine Welligkeit der Zellspannung beschreibt, und die Recheneinrichtung (5) dazu ausgebildet ist, das Zellspannungssignal in Abhängigkeit von dem Welligkeitswert auszuwerten, und dazu ausgebildet ist, eine Spannungswelligkeit der Gesamtspannung in einem vorbestimmten Frequenzbereich, insbesondere in einem Frequenzbereich zwischen 50 Hz und 2 kHz, zu bestimmen, wobei diese Spannungswelligkeit ein zu berücksichtigendes Maß für eine maximale Aliasing-induzierte Messabweichung auf Zellebene ist, und die Spannungswelligkeit für die Batteriezelle zu skalieren sowie die gefilterte Zellspannung mit einer vorbestimmten Abtastrate, insbesondere einer Abtastrate zwischen 50 Hz und 200 Hz, welche Aliasing-Effekte bei der Zellspannungsbestimmung hervorruft, abzutasten.

## Claims

1. Method for determining an electrical cell voltage of a battery cell of a traction battery of a vehicle, in which, in order to provide a cell voltage signal which describes the cell voltage of the battery cell, the cell voltage of the battery cells is filtered using a filter device (3) and the filtered cell voltage is sampled using an analog-to-digital converter (4), wherein the cell voltage signal is evaluated and wherein the cell voltage is filtered using a low-pass filter, in particular a low-pass filter having a corner frequency between 500 Hz and 1.5 kHz, and the filtered cell voltage is sampled at a predetermined sampling rate, in particular a sampling rate between 50 Hz and 200 Hz,
**characterized in that**
- a ripple value is additionally provided, which describes a ripple of the cell voltage, and an electrical total voltage of the traction battery is determined for determining the ripple value;
- the cell voltage signal is evaluated on the basis of the ripple value;
- a voltage ripple of the total voltage is determined in a predetermined frequency range, in particular in a frequency range between 50 Hz and 2 kHz, wherein this voltage ripple is a measurement that is to be taken into account for a maximum aliasing-induced measurement deviation at cell level;
- the voltage ripple for the battery cell is scaled.

2. Apparatus (1) for determining an electrical cell voltage of a battery cell of a traction battery of a vehicle, comprising a first sensor (2) for detecting the cell voltage, a filter device (3) for filtering the cell voltage, an analog-to-digital converter (4) for sampling the filtered cell voltage and for outputting the filtered and sampled cell voltage as a cell voltage signal, and comprising a computing device (5) for evaluating the cell voltage signal,
**characterized in that**
the apparatus (1) has a second sensor (6) for providing a ripple value, wherein the ripple value describes a ripple of the cell voltage, and the computing device (5) is designed to evaluate the cell voltage signal on the basis of the ripple value, and is designed to determine a voltage ripple of the total voltage in a predetermined frequency range, in particular in a frequency range between 50 Hz and 2 kHz, wherein this voltage ripple is a measurement that is to be taken into account for a maximum aliasing-induced measurement deviation at cell level, and to scale the voltage ripple for the battery cell and sample the filtered cell voltage at a predetermined sampling rate, in particular a sampling rate between 50 Hz and 200 Hz, which causes aliasing effects in the cell voltage determination.

## Revendications

1. Procédé permettant de déterminer une tension électrique de cellule d'une cellule de batterie d'une batterie de traction d'un véhicule, dans lequel, pour mettre à disposition un signal de tension de cellule, qui décrit la tension de cellule de la cellule de batterie, la tension de cellule de la cellule de batterie est filtrée avec un appareil de filtre (3) et la tension de cellule filtrée est échantillonnée avec un convertisseur analogique-numérique (4), dans lequel le signal de tension de cellule est évalué, dans lequel la tension de cellule est filtrée avec un filtre passe-bas, en particulier un filtre passe-bas comportant une fréquence de transition comprise entre 500 Hz et 1,5 kHz, et la tension de cellule filtrée est échantillonnée à un taux d'échantillonnage prédéfini, en particulier un taux d'échantillonnage compris entre 50 Hz et 200 Hz,
**caractérisé en ce que**
- de plus, une valeur d'ondulation est fournie, qui décrit une ondulation de la tension de cellule et, pour déterminer la valeur d'ondulation, une tension électrique totale de la batterie de traction est déterminée ;
- le signal de tension de cellule est évalué en fonction de la valeur d'ondulation ;
- une ondulation de tension de la tension totale est déterminée dans une plage de fréquences prédéfinie, en particulier dans une plage de fréquences comprise entre 50 Hz et 2 kHz, dans lequel cette ondulation de tension est une mesure à prendre en compte pour un écart de mesure maximal induit par un repliement au niveau de la cellule ;
- l'ondulation de tension est mise à l'échelle pour la cellule de batterie.

2. Dispositif (1) permettant de déterminer une tension électrique de cellule d'une cellule de batterie d'une batterie de traction d'un véhicule, comportant un premier capteur (2) permettant de détecter la tension de cellule, comportant un appareil de filtre (3) permettant de filtrer la tension de cellule, comportant un convertisseur analogique-numérique (4) permettant d'échantillonner la tension de cellule filtrée ainsi que d'émettre la tension de cellule filtrée et échantillonnée en tant que signal de tension de cellule et comportant un appareil de calcul (5) permettant d'évaluer le signal de tension de cellule,
**caractérisé en ce que**
le dispositif (1) présente un second capteur (6) permettant de fournir une valeur d'ondulation, dans lequel la valeur d'ondulation décrit une ondulation de la tension de cellule et l'appareil de calcul (5) est conçu pour évaluer le signal de tension de cellule en fonction de la valeur d'ondulation et est conçu pour déterminer une ondulation de tension de la tension totale dans une plage de fréquences prédéfinie, en particulier dans une plage de fréquences comprise entre 50 Hz et 2 kHz, dans lequel cette ondulation de tension est une mesure à prendre en compte pour un écart de mesure maximal induit par un repliement et pour mettre à l'échelle l'ondulation de tension pour la cellule de batterie, ainsi que pour échantillonner la tension de cellule filtrée avec un taux d'échantillonnage prédéfini, en particulier un taux d'échantillonnage compris entre 50 Hz et 200 Hz, qui provoque des effets de repliement lors de la détermination de tension de cellule.
